# EUROPEAN PATENT APPLICATION

(11) **EP 4 478 412 A1**
(43) Date of publication of application: **18.12.2024**
(21) Application number: 23777573.9
(22) Date of filing: 05.01.2023
(51) Int. Cl.: H01L 25/16

(54) **PHOTOELECTRIC CO-PACKAGING STRUCTURE AND COMMUNICATION DEVICE**

(30) Priority: 31.03.2022 CN 202210331667
(71) Applicant: Huawei Technologies Co., Ltd., Shenzhen, Guangdong 518129 (CN)
(72) Inventor: ZHANG, Shun, Shenzhen, Guangdong 518129 (CN); WANG, Wenyi, Shenzhen, Guangdong 518129 (CN); CHEN, Chong, Shenzhen, Guangdong 518129 (CN); ZHAI, Ning, Shenzhen, Guangdong 518129 (CN)
(74) Representative: Grünecker Patent- und Rechtsanwälte PartG mbB
(86) International application number: PCT/CN2023/070781
(87) International publication number: WO 2023/185194

(57) **Abstract**

Embodiments of this application provide an optical-electrical co-package structure and a communication device. The optical-electrical co-package structure includes a carrier circuit board, an optical-electrical conversion module, a package circuit board, and an electrical chip. The package circuit board and the optical-electrical conversion module are respectively located on a first side surface and a second side surface that are opposite to each other of the carrier circuit board. The electrical chip is disposed on the package circuit board, and the optical-electrical conversion module is separated from the package circuit board, to significantly reduce a size of the package circuit board, reduce processing difficulty and costs of the package circuit board, and reduce a loss of a high-speed signal transmission link. In addition, the carrier circuit board is provided with a first conductive via, and the package circuit board is electrically connected to the optical-electrical conversion module directly through the first conductive via, to reduce inter-board traces on a connection link between the optical-electrical conversion module and the package circuit board, shorten a signal transmission path, significantly reduce a high-speed link loss, avoid high-speed inter-board traces, and help reduce processing difficulty and costs of the carrier circuit board.

## Description

This application claims priority to Chinese Patent Application No. 202210331667.4, filed with the Chinese Patent Office on March 31, 2022 and entitled "OPTICAL-ELECTRICAL CO-PACKAGE STRUCTURE AND COMMUNICATION DEVICE", which is incorporated herein by reference in its entirety.

### TECHNICAL FIELD

This application relates to the field of communication technologies, and in particular, to an optical-electrical co-package structure and a communication device.

### BACKGROUND

An optical communication technology has become a large-capacity, low-cost, and batch productization technology, and is widely applied to switch interconnection, server interfaces, and other applications. In the optical communication technology, a connection between an optical fiber carrying data and a network communication device such as a switch needs to be implemented. A optical-electrical co-package technology has become one of hot technologies that can implement a connection with a higher rate and higher bandwidth.

Currently, optical-electrical co-package is to package an optical-electrical conversion module and an electrical chip on a same substrate. Specifically, a mechanical part for co-packaging may include a package circuit board, and the electrical chip and the optical-electrical conversion module are disposed on a same surface of the package circuit board. There are generally a plurality of optical-electrical conversion modules, the plurality of optical-electrical conversion modules are disposed around a periphery of the electrical chip, and the optical-electrical conversion modules are connected to the electrical chip. When the mechanical part for co-packaging is used in a device such as a switch, the package circuit board may be disposed on a control circuit board in the switch and electrically connected to the control circuit board. A panel of the switch is provided with an optical interface, the optical interface is electrically connected to the optical-electrical conversion module, and an external optical fiber may be connected to the optical interface, so that the external optical fiber is connected to the optical-electrical conversion module, and the external optical fiber is further connected to the electrical chip through the optical-electrical conversion module. In this way, a connection between an optical cable and a device such as the switch can be implemented.

However, the electrical chip and the optical-electrical conversion module are located on the same surface of the package circuit board, resulting in an increase in a size of the package circuit board, high packaging costs, and a high link loss.

### SUMMARY

This application provides an optical-electrical co-package structure and a communication device, to resolve a problem that an electrical chip and an optical-electrical conversion module are located on a same surface of a package circuit board in an existing optical-electrical co-package structure, resulting in an increase in a size of the package circuit board, an increase in packaging costs, and an increase in a link loss.

A first aspect of this application provides an optical-electrical co-package structure, including a carrier circuit board, an optical-electrical conversion module, a package circuit board, and an electrical chip.

The carrier circuit board includes a first side surface and a second side surface opposite to the first side surface, the package circuit board is located on the first side surface, the electrical chip is disposed on the package circuit board, the electrical chip is electrically connected to the package circuit board, and the optical-electrical conversion module is disposed on the second side surface. In other words, the optical-electrical conversion module is separated and decoupled from the package circuit board, and the optical-electrical conversion module and the package circuit board are disposed on two opposite side surfaces of the carrier circuit board respectively, so that it can be ensured that a disposition of the optical-electrical conversion module does not affect a size of the package circuit board, to significantly reduce the size of the package circuit board, reduce processing difficulty and costs of the package circuit board, and facilitate processing and implementation of the package circuit board. A reduction in the size of the package circuit board can help reduce a loss of a signal transmission link to improve transmission effect, help reduce limitations on a size and the like of a connecting pin on the package circuit board to further reduce processing difficulty of the package circuit board, and help improve connection reliability of an entire transmission link.

The carrier circuit board is provided with a first conductive via, and the optical-electrical conversion module is electrically connected to the package circuit board through the first conductive via. A direct electrical connection between the optical-electrical conversion module and the package circuit board is implemented by using the first conductive via. Inter-board traces on a high-speed connection link between the optical-electrical conversion module and the package circuit board are reduced, a signal transmission path is shortened, a high-speed link loss is significantly reduced, and signal transmission quality is improved. In other words, the size of the package circuit board is reduced, a transmission link loss is effectively reduced, and signal transmission quality is improved. In addition, inter-board high-speed traces and an expensive high-speed board are avoided, which helps reduce processing costs and processing difficulty of the carrier circuit board.

In a possible implementation, a vertical projection of the optical-electrical conversion module onto the carrier circuit board is a first projection, a vertical projection of the package circuit board onto the carrier circuit board is a second projection, and at least a part of the first projection overlaps the second projection. To be specific, spaces on the carrier circuit board occupied by the optical-electrical conversion module and the package circuit board at least partially coincide. In this way, the spaces on the carrier circuit board occupied by the optical-electrical conversion module and the package circuit board can be reduced, which helps reduce a size of the carrier circuit board, and helps reduce processing difficulty and processing costs of the carrier circuit board. In addition, this helps shorten a distance between the optical-electrical conversion module and the package circuit board, and helps shorten a path of a connection link between the optical-electrical conversion module and the package circuit board, so that the optical-electrical conversion module and the package circuit board can be electrically connected through the first conductive via.

In a possible implementation, a first pin is disposed on a surface that is of the package circuit board and that faces the carrier circuit board, a second pin is disposed on a surface that is of the optical-electrical conversion module and that faces the carrier circuit board, and two ends of the first conductive via are electrically connected to the first pin and the second pin respectively. In this way, the optical-electrical conversion module and the package circuit board can be electrically connected through the first conductive via.

In a possible implementation, a vertical projection of the first pin onto the carrier circuit board coincides with a vertical projection of the second pin onto the carrier circuit board, and an extension direction of the first conductive via is perpendicular to the carrier circuit board. In other words, the extension direction of the first conductive via is a direction that passes through the first pin and the second pin and that is perpendicular to the carrier circuit board. In this way, it is ensured that the optical-electrical conversion module and the package circuit board are connected directly through the first conductive via, and an extension length of the first conductive via can be reduced. This helps further shorten a path of a connection link between the optical-electrical conversion module and the electrical chip, and reduce a high-speed link loss.

In a possible implementation, a vertical projection of the first pin onto the carrier circuit board is staggered with a vertical projection of the second pin onto the carrier circuit board. This reduces constraints on an arrangement and a disposition of the first pin and the second pin, increases flexibility of disposing the first pin and the second pin, and enriches application scenarios of the optical-electrical co-package structure.

In a possible implementation, the carrier circuit board includes at least two layers of substrates disposed in a stacked manner.

Each layer of the substrates is provided with a connecting via, the connecting vias on at least two layers of the substrates are staggered, and the connecting vias on two adjacent layers of the substrates are electrically connected to form the first conductive via. Connecting vias on at least two layers are staggered, and adjacent connecting vias are connected to form the first conductive via, so that the first pin and the second pin whose projections onto the carrier circuit board are staggered are electrically connected through the first conductive via.

In a possible implementation, the carrier circuit board further includes a metal layer, the metal layer is disposed between the connecting vias on two adjacent layers of the substrates, and the connecting vias are connected through the metal layer. This can effectively increase an electrical contact area between the two connecting vias, reduce or avoid instability of an electrical connection caused by stagger of the connecting vias on the two adjacent layers of the substrates, and improve stability of an electrical connection between the connecting vias.

In a possible implementation, the first conductive via includes a through hole, a blind hole, or a buried hole.

In a possible implementation, a power supply module is further included, the power supply module is electrically connected to the optical-electrical conversion module, and the power supply module is disposed on the carrier circuit board. The power supply module is configured to supply power to the optical-electrical conversion module, to help ensure stability and flexibility of supplying power to the optical-electrical module.

In a possible implementation, the carrier circuit board is further provided with a second conductive via, the power supply module is disposed on the first side surface, and the power supply module is electrically connected to the optical-electrical conversion module through the second conductive via. To be specific, the power supply module and the optical-electrical conversion module are located on two opposite side surfaces of the carrier circuit board, and the power supply module and the optical-electrical conversion module can be electrically connected directly through the second conductive via, without using an inter-board trace (for example, a trace of the carrier circuit board) to connect the power supply module to the optical-electrical conversion module. This helps shorten a path of a connection link and further reduce a link loss.

In a possible implementation, a third pin is disposed on the surface that is of the optical-electrical conversion module and that faces the carrier circuit board, a fourth pin is disposed on the power supply module, and two ends of the second conductive via are connected to the third pin and the fourth pin respectively. In this way, the power supply module and the optical-electrical conversion module are electrically connected through the second conductive via.

In a possible implementation, the optical-electrical conversion module includes a first part and a second part, a vertical projection of the first part onto the carrier circuit board overlaps the second projection, a vertical projection of the second part onto the carrier circuit board is located outside the second projection, the first pin is located on the first part, and the third pin is located on the second part.

A vertical projection of the third pin onto the carrier circuit board coincides with a vertical projection of the fourth pin onto the carrier circuit board, and an extension direction of the second conductive via is perpendicular to the carrier circuit board. To be specific, the extension direction of the second conductive via is a direction that passes through the third pin and the fourth pin and that is perpendicular to the carrier circuit board. It is ensured that the optical-electrical conversion module and the power supply module are connected directly through the second conductive via, and an extension length of the second conductive via can be reduced. This helps further shorten a path of a connection link between the power supply module and the optical-electrical conversion module, reduce a link loss, and improve power supply efficiency of a power module.

A second aspect of this application provides a communication device, including at least a housing and the optical-electrical co-package structure according to any one of the foregoing implementations. The optical-electrical co-package structure is disposed in the housing.

The housing is provided with an optical interface configured to connect to an external optical fiber, and the optical interface is connected to the optical-electrical conversion module. In the optical-electrical co-package structure, the package circuit board for packaging the electrical chip has a small size, is easy to process and implement, helps reduce processing difficulty and processing costs of the entire communication device, and has higher connection stability. In addition, the optical-electrical co-package structure has a low loss of a high-speed transmission link, and can effectively improve transmission performance of the communication device.

In a possible implementation, a control circuit board is further included, the carrier circuit board is disposed on the control circuit board, and the carrier circuit board is electrically connected to the control circuit board. To be specific, a control board is additionally disposed in the communication device. This helps reduce design difficulty of the control circuit board, and facilitates processing and implementation of the control circuit board and the optical-electrical co-package structure, compared with using the carrier circuit board in the optical-electrical co-package structure as a control board.

In a possible implementation, an internal optical fiber located in the housing is further included, and the optical interface is connected to the optical-electrical conversion module through the internal optical fiber. In this way, the external optical fiber is electrically connected to the optical-electrical conversion module, so that the external optical fiber is electrically connected to the electrical chip, to implement signal transmission between the communication device and the external optical fiber.

### BRIEF DESCRIPTION OF DRAWINGS

FIG. 1 is a diagram of a structure of a communication device according to an embodiment of this application;
FIG. 2 is a diagram of signal transmission in a communication device according to an embodiment of this application;
FIG. 3 is a schematic front view of an optical-electrical co-package structure in a conventional technology;
FIG. 4 is an assembly diagram of an optical-electrical co-package structure and a control circuit board in a conventional technology;
FIG. 5 is a diagram of a connection scenario of an optical-electrical co-package structure in a communication device in a conventional technology;
FIG. 6 is a diagram of another optical-electrical co-package structure in a conventional technology;
FIG. 7 is a schematic front view of an optical-electrical co-package structure according to an embodiment of this application;
FIG. 8 is a schematic cross-sectional view of an optical-electrical co-package structure according to an embodiment of this application;
FIG. 9 is a diagram of a size of a package circuit board in an optical-electrical co-package structure according to an embodiment of this application;
FIG. 10 is a diagram of a cross-sectional structure of a communication device according to an embodiment of this application;
FIG. 11 is an assembly diagram of a co-package structure and a control circuit board according to an embodiment of this application;
FIG. 12 is a diagram of another optical-electrical co-package structure according to an embodiment of this application;
FIG. 13 is another assembly diagram of an optical-electrical co-package structure and a control circuit board according to an embodiment of this application; and
FIG. 14 is a diagram of still another optical-electrical co-package structure according to an embodiment of this application.

### Reference numerals:

100: communication device; 10: optical-electrical co-package structure; 11: carrier circuit board;
111: first side surface; 112: second side surface; 113: first conductive via;
114: substrate; 115: connecting via; 116: metal layer;
117: second conductive via; 12: optical-electrical conversion module; 12a: first part;
12b: second part; 121: second pin; 122: third pin;
13: package circuit board; 131: first pin; 14: electrical chip;
15: power supply module; 16: protective member; 20: housing;
21: panel; 211: optical interface; 30: control circuit board;
40: internal optical fiber.

### DESCRIPTION OF EMBODIMENTS

Terms used in embodiments of this application are merely used to explain specific embodiments of this application, but are not intended to limit this application.

A communication device provided in an embodiment of this application may be a communication device used for signal interaction, for example, a switch, a router, a network transmission device, or a broadband access device. An example in which the communication device is a switch is used below for description.

Signal transmission between the switch and an external optical fiber is mainly implemented by using an optical-electrical conversion module. Specifically, the external optical fiber is connected to the optical-electrical conversion module, the optical-electrical conversion module is electrically connected to an electrical chip of the communication device, and the optical-electrical conversion module is configured to implement conversion from an optical signal into an electrical signal and conversion from an electrical signal into an optical signal, to implement signal transmission between the electrical chip of the communication device and the external optical fiber.

Specifically, an optical signal on the external optical fiber is converted into an electrical signal by the optical-electrical conversion module and then transmitted to the electrical chip, so that the signal is transmitted from the external optical fiber to the communication device. An electrical signal of the electrical chip is converted into an optical signal by the optical-electrical conversion module and then transmitted to the external optical fiber, so that the signal is transmitted from the communication device to the external optical fiber.

As optical communication technologies evolve toward high speeds and large capacities, a co-packaged optics (Co-packaged Optics, CPO) technology has attracted wide attention. In the co-packaged optics technology, an optical engine (Optical engine, OE, also referred to as an optical-electrical conversion module) and an electrical chip are co-packaged, and a packaged structure is used in a communication device such as a switch, to implement signal transmission between the communication device and an external optical fiber.

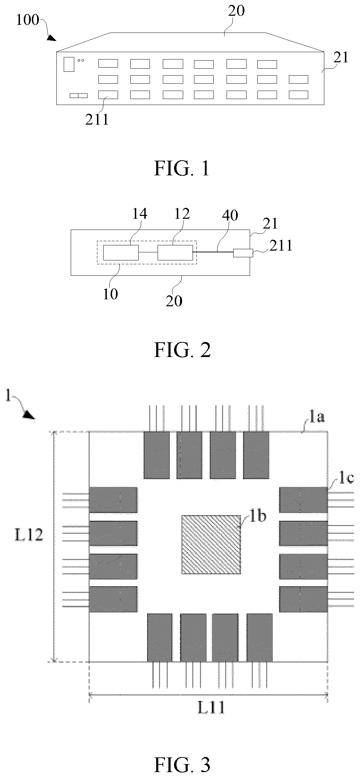

FIG. 1 is a diagram of a structure of a communication device according to an embodiment of this application. FIG. 2 is a diagram of signal transmission in a communication device according to an embodiment of this application.

As shown in FIG. 1, a communication device 100 includes a housing 20, the housing 20 may include a panel 21, and the panel 21 may be located on a front of the entire communication device 100, that is, located on a front of an appearance of the entire communication device 100. The panel 21 may be provided with an optical interface 211, and the optical interface 211 is configured to connect to an external optical fiber.

There may be one or more optical interfaces 211. When there are a plurality of optical interfaces 211, the plurality of optical interfaces 211 may be arranged on the panel 21 in a multi-row parallel manner.

As shown in FIG. 2, an optical-electrical co-package structure 10 is disposed in the housing 20. The optical-electrical co-package structure 10 may include an optical-electrical conversion module 12 and an electrical chip 14. The electrical chip 14 is electrically connected to the optical-electrical conversion module 12.

An internal optical fiber 40 is further disposed in the housing 20. The optical-electrical conversion module 12 may be connected to the optical interface 211 through the internal optical fiber 40, and the optical interface 211 is connected to an external optical fiber. In this way, the external optical fiber is connected to the optical-electrical conversion module 12, so that the external optical fiber is connected to the electrical chip 14, to implement signal transmission between the external optical fiber and the communication device 100.

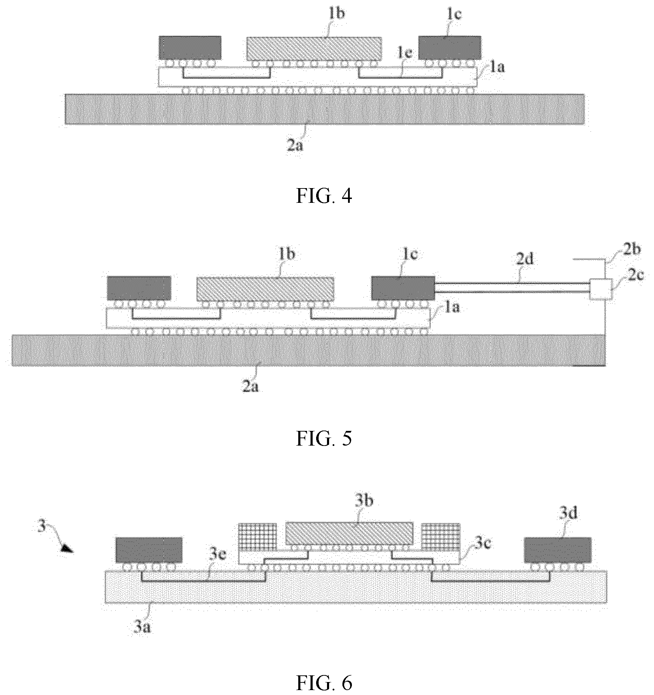

FIG. 3 is a schematic front view of an optical-electrical co-package structure in a conventional technology. FIG. 4 is an assembly diagram of an optical-electrical co-package structure and a control circuit board in a conventional technology.

In a common optical-electrical co-package structure, an optical-electrical conversion module and an electrical chip are usually packaged on a same substrate. For example, as shown in FIG. 3, an optical-electrical co-package structure 1 may include a package circuit board 1a, an electrical chip 1b, and an optical-electrical conversion module 1c. The electrical chip 1b and the optical-electrical conversion module 1c are disposed on a same surface of the package circuit board 1a. There are a plurality of optical-electrical conversion modules 1c, and the plurality of optical-electrical conversion modules 1c are disposed around a periphery of the electrical chip 1b.

As shown in FIG. 4, the optical-electrical conversion module 1c is electrically connected to the electrical chip 1b through a trace 1e of the package circuit board 1a, to implement signal transmission between the electrical chip 1b and an external optical fiber.

FIG. 5 is a diagram of a connection scenario of an optical-electrical co-package structure in a communication device in a conventional technology.

As shown in FIG. 5, an example in which the optical-electrical co-package structure 1 is used in a switch is used. The package circuit board 1a may be disposed on a control circuit board 2a of the switch, and the optical-electrical conversion module 1c may be electrically connected to the control circuit board 2a, to implement transmission of a control signal, a power supply signal, or the like. A panel 2b of a housing of the switch is provided with an optical interface 2c. The optical interface 2c is electrically connected to the optical-electrical conversion module 1c through an internal optical fiber 2d. A transmission link between the switch and an external optical fiber is the electrical chip 1b, the package circuit board 1a, the optical-electrical conversion module 1c, and the external optical fiber.

However, the optical-electrical conversion module 1c and the electrical chip 1b are located on the same surface of the package circuit board 1a, and the optical-electrical conversion module 1c occupies a large space of the package circuit board 1a. As a result, a size of the package circuit board 1a is larger, and processing difficulty and processing costs of the package circuit board 1a are increased. For example, FIG. 3 shows a common optoelectronic hybrid-packaged structure with a capacity of 51.2 T, and 16 optical-electrical conversion modules of 3.2 T are disposed on the package circuit board. A length L11 and a width L12 of the package circuit board are approximately 126 mm and 126 mm. This exceeds a current processing capability and cannot be implemented because a processing limit on a size of the package circuit board 1a for the electrical chip 1b is currently 110 mm* 100 mm.

In addition, an increase in the size of the package circuit board 1a causes an increase in a high-speed link loss. Generally, the increase in the link loss due to the increase in the size of the package circuit board 1a is 0.14 dB/mm to 0.18 dB/mm. The link loss needs to be further reduced.

In addition, a power supply signal or the like transmitted between the optical-electrical conversion module 1c and the control circuit board 2a needs to be transmitted through the package circuit board 1a, and an increase in connecting pins or the like on the package circuit board 1a also causes increases in the size and processing difficulty of the package circuit board 1a. Generally, sizes of the optical-electrical conversion module 1c and connecting pins (for example, pins for implementing connections between the optical-electrical conversion module and the electrical chip and the package circuit board) are reduced, to control the size of the package circuit board 1a. For example, the pin is required to be less than 0.5 mm. Processing difficulty of a small pin and a small optical-electrical conversion module 1c is high, and a risk in contact reliability is high, which reduces connection reliability of an entire link.

FIG. 6 is a diagram of another optical-electrical co-package structure in a conventional technology.

In the conventional technology, a near-packaged optics (Near-packaged Optics, NPO) technology is used to dispose an optical-electrical conversion module and an electrical chip on different substrates, for reducing a size of a package circuit board to facilitate processing of the package circuit board. Specifically, as shown in FIG. 6, an optical-electrical co-package structure 3 includes a transfer circuit board 3a, a package circuit board 3c, an electrical chip 3b, and an optical-electrical conversion module 3d. The package circuit board 3c and the optical-electrical conversion module 3d are disposed on a same surface of the transfer circuit board 3a. A plurality of optical-electrical conversion modules 3d are disposed around a periphery of the package circuit board 3c. The electrical chip 3b is disposed on a surface that is of the package circuit board 3c and that faces away from the transfer circuit board 3a. The optical-electrical conversion module 3d is electrically connected to the package circuit board 3c through a trace 3e of the transfer circuit board 3a, to be electrically connected to the electrical chip 3b. In this case, the optical-electrical conversion module 3d is separated from the package circuit board 3c, and the optical-electrical conversion module 3d is disposed without occupying a space of the package circuit board 3c, to reduce a size of the package circuit board 3c and facilitate processing and implementation of the package circuit board 3c.

The optical-electrical co-package structure 3 is used in a switch (with reference to FIG. 5), the transfer circuit board 3a is disposed on a control circuit board of the switch, and an optical interface is electrically connected to the optical-electrical conversion module 3d through an internal optical fiber. A transmission link between the switch and an external optical fiber is the electrical chip 3b, the package circuit board 3c, the trace 3e of the transfer circuit board, the optical-electrical conversion module 3d, and the external optical fiber.

However, the optical-electrical conversion module 3d is electrically connected to the package circuit board 3c through the trace 3e of the transfer circuit board 3a, the trace 3e of the transfer circuit board increases a loss of a high-speed connection link, and a link loss of the trace is generally 0.05 dB/mm to 0.08 dB/mm. The trace 3e of the transfer circuit board is a trace for implementing high-speed signal transmission. In this case, the transfer circuit board 3a needs to be a high-speed board, which increases costs of the transfer circuit board 3a. In addition, existence of the trace increases a layer quantity of the transfer circuit board 3a, and increases processing difficulty of the transfer circuit board 3a.

In view of this, embodiments of this application provide an optical-electrical co-package structure, for effectively reducing a size of a package circuit board to reduce packaging difficulty and costs, and effectively reducing a loss of a high-speed signal transmission link to help signal transmission develop toward a high speed and a large capacity.

With reference to accompanying drawings, the following describes in detail an optical-electrical co-package structure provided in embodiments of this application and a disposition of the optical-electrical co-package structure in a communication device.

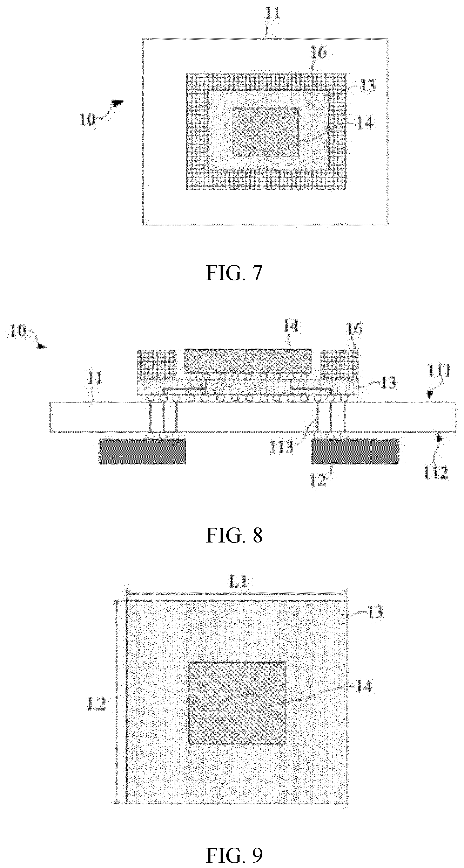

FIG. 7 is a schematic front view of an optical-electrical co-package structure according to an embodiment of this application.

As shown in FIG. 7, an optical-electrical co-package structure 10 includes a package circuit board 13 and an electrical chip 14. The package circuit board 13 is configured to package the electrical chip 14, the electrical chip 14 is disposed on the package circuit board 13, and the electrical chip 14 is a carrier of an integrated circuit. For example, the electrical chip 14 may be a silicon chip.

The electrical chip 14 may be a bare die (Die), or the electrical chip 14 may be a chip integrated with an electronic component. For example, the electrical chip 14 may be a silicon chip integrated with an electronic component such as a processor or a memory. The electrical chip 14 may be fastened to the package circuit board 13 through soldering or the like.

A protective member 16 is further disposed on the package circuit board 13, and the protective member 16 is disposed around a periphery of the electrical chip 14, to package and protect the electrical chip 14. The protective member 16 may be an insulating mechanical part such as resin or silicone, and the protective member 16 may be disposed on the package circuit board 13 through bonding or the like.

The package circuit board 13 may be a printed circuit board (Printed Circuit Board, PCB) or a substrate (Substrate). For example, the package circuit board 13 may be a rigid printed circuit board and can provide rigid support, to ensure disposition stability of the electrical chip 14.

FIG. 8 is a schematic cross-sectional view of an optical-electrical co-package structure according to an embodiment of this application.

As shown in FIG. 8, the optical-electrical co-package structure 10 further includes a carrier circuit board 11 and an optical-electrical conversion module 12. The carrier circuit board 11 includes at least a first side surface 111 and a second side surface 112, and the first side surface 111 and the second side surface 112 are two opposite side surfaces of the carrier circuit board 11. The package circuit board 13 is disposed on the first side surface 111 of the carrier circuit board 11, and the electrical chip 14 is disposed on the package circuit board 13. Specifically, the electrical chip 14 may be located on a surface that is of the package circuit board 13 and that faces away from the carrier circuit board 11.

The optical-electrical conversion module 12 is disposed on the second side surface 112 of the carrier circuit board 11, that is, the optical-electrical conversion module 12 is separated and decoupled from the package circuit board 13. The optical-electrical conversion module 12 and the package circuit board 13 are disposed on two opposite side surfaces of the carrier circuit board 11 respectively, so that it can be ensured that a disposition of the optical-electrical conversion module 12 does not affect a size of the package circuit board 13, to significantly reduce the size of the package circuit board 13, reduce processing difficulty and processing costs of the package circuit board 13, and facilitate processing and implementation of the package circuit board 13.

A reduction in the size of the package circuit board 13 can help reduce a loss of a high-speed signal transmission link between the electrical chip and the optical-electrical conversion module to improve transmission effect, help reduce limitations on a size and the like of a connecting pin on the package circuit board 13 to further reduce processing difficulty of the package circuit board 13, and help improve connection reliability of an entire transmission link. The reduction in the size can further help improve flatness of the package circuit board 13, improve quality of connections between the package circuit board 13 and the carrier circuit board 11, the electrical chip 14, and the like, and improve packaging reliability.

In addition, a heat dissipation module or the like (not shown in the figure) is usually disposed around the electrical chip 14. The package circuit board 13 and the electrical chip 14, and the optical-electrical conversion module 12 are disposed on two opposite sides of the carrier circuit board 11, to avoid interference between the heat dissipation module and the optical-electrical conversion module 12, and improve rationality of a layout of the optical-electrical co-package structure 10.

Still refer to FIG. 8. The carrier circuit board 11 is provided with a first conductive via 113. The optical-electrical conversion module 12 and the package circuit board 13 are located on two opposite side surfaces of the carrier circuit board 11 respectively, and the optical-electrical conversion module 12 may be electrically connected to the package circuit board 13 through the first conductive via 113, so that the optical-electrical conversion module 12 is electrically connected to the electrical chip 14.

In other words, a direct electrical connection between the optical-electrical conversion module 12 and the package circuit board 13 is implemented by using the first conductive via 113. Compared with the connection between the optical-electrical conversion module and the package circuit board implemented by using the trace of the transfer circuit board in the conventional technology, inter-board traces on a high-speed connection link between the optical-electrical conversion module 12 and the package circuit board 13 are reduced, a signal transmission path is shortened, a high-speed link loss is significantly reduced, where the link loss may be reduced by approximately 2 dB to 3 dB, and signal transmission quality is effectively improved. In other words, the optical-electrical co-package structure 10 provided in embodiments of this application can effectively reduce a transmission link loss and improve signal transmission quality when reducing the size of the package circuit board 13.

In addition, the optical-electrical conversion module 12 is connected to the package circuit board 13 through the first conductive via 113, so that inter-board high-speed traces and an expensive high-speed board can be avoided to reduce processing costs of the carrier circuit board 11, and a layer quantity of the carrier circuit board 11 can be reduced and structure design can be simplified to reduce processing difficulty of the carrier circuit board 11.

The package circuit board 13 may be fastened to the carrier circuit board 11 through soldering or the like. Alternatively, the optical-electrical co-package structure 10 may further include a socket connector (Socket connector), the package circuit board 13 may be vertically plugged into the carrier circuit board 11 through the socket connector, and the package circuit board 13 is electrically connected to the carrier circuit board through the socket connector.

It should be noted that in embodiments of this application, the optical-electrical co-package structure 10 may include one or more optical-electrical conversion modules 12, to satisfy a high-density connection requirement of a communication device. Specifically, when there are a plurality of optical-electrical conversion modules 12, the plurality of optical-electrical conversion modules 12 may be distributed on the carrier circuit board 11 along a periphery direction of the package circuit board 13.

The optical-electrical conversion module 12 may also be fastened to the carrier circuit board 11 through soldering or the like. Alternatively, the optical-electrical conversion module 12 may also be vertically plugged into the carrier circuit board 11 through a socket connector, and the optical-electrical conversion module 12 is electrically connected to the carrier circuit board 11 through the socket connector.

The optical-electrical conversion module 12 may be any mechanical part that can implement conversion between an optical signal and an electrical signal. For example, the optical-electrical conversion module 12 may be an integrated structure of an active component and a passive component. Specifically, the active component may include a driver, a modulator, an optical detector, a trans-impedance amplifier, and the like.

The driver is connected to the modulator, and the driver is configured to amplify an electrical signal, so that amplitude of the electrical signal satisfies a requirement for driving the modulator. The modulator is configured to convert an electrical signal into an optical signal, and the optical detector is configured to convert an optical signal into an electrical signal. The trans-impedance amplifier is configured to convert a weak electrical signal into an amplified electrical signal, to satisfy an input amplitude requirement of a subsequent signal processing circuit (for example, the electrical chip 14).

The passive component of the optical-electrical conversion module 12 may include an optical waveguide, an optical grating, an optical fiber, and the like, and can implement a function such as transmitting or enhancing an optical signal.

As shown in FIG. 8, there may be a plurality of first conductive vias 113 on the carrier circuit board 11, the plurality of first conductive vias 113 are arranged at spacings, and one optical-electrical conversion module 12 may be electrically connected to the package circuit board 13 through a plurality of first conductive vias 113. A quantity of first conductive vias 113 may be set according to an actual connection requirement.

The first conductive via 113 on the carrier circuit board 11 may be a metallized via, and the first conductive via 113 may be a through hole, a blind hole, a buried hole, or the like that is provided on the carrier circuit board 11, provided that an electrical conduction function can be implemented. A metallization manner may be electroplating and filling, hole plugging, or the like. This is not limited in embodiments of this application.

The carrier circuit board 11 may be a PCB, or the carrier circuit board 11 may be a carrier board, an organic substrate, a ceramic board, or the like that has only a carrier and supporting function, provided that the carrier circuit board 11 has a supporting function and can be provided with a first conductive via 113 (and a second conductive via) to implement an electrical connection.

FIG. 9 is a diagram of a size of a package circuit board in an optical-electrical co-package structure according to an embodiment of this application.

In FIG. 3, the length L11 of the package circuit board 13 and the width L12 of the package circuit board 13 are 126 mm and 126 mm. In this embodiment of this application, the optical-electrical co-package structure 10 has a capacity of 51.2 T, and 16 optical-electrical conversion modules 12 of 3.2 T are disposed on the carrier circuit board 11. As shown in FIG. 9, a length L1 of the package circuit board 13 and a width L2 of the package circuit board 13 only need to be approximately 90 mm and 90 mm. This significantly reduces the length and the width of the package circuit board 13, so that the package circuit board 13 can satisfy a processing limit requirement of a current package circuit board, and processing difficulty and processing costs of the package circuit board 13 are reduced.

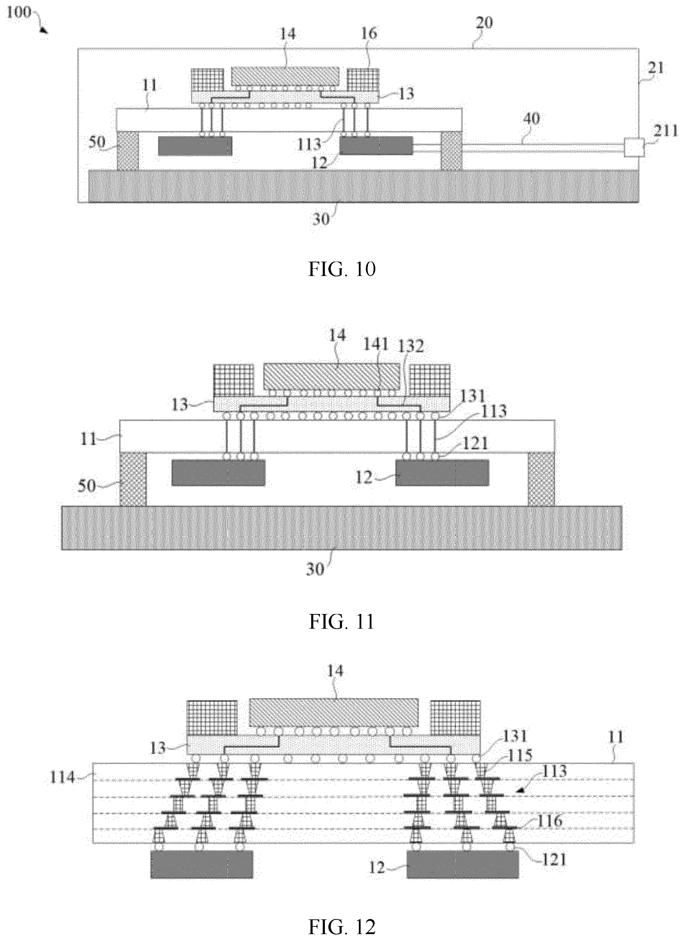

FIG. 10 is a diagram of a cross-sectional structure of a communication device according to an embodiment of this application.

When the optical-electrical co-package structure 10 is used in a communication device 100 such as a switch, the carrier circuit board 11 may be used as a control circuit board of the communication device 100, and the control circuit board is configured to control overall running of the communication device.

Alternatively, as shown in FIG. 10, a control circuit board 30 may be additionally disposed in the communication device 100, that is, the carrier circuit board 11 is used as a transfer board that has a carrier and transfer function. This helps reduce design difficulty of the control circuit board 30, and facilitates processing and implementation of the control circuit board 30 and the optical-electrical co-package structure 10.

The following uses, for description, an example in which the carrier circuit board 11 is used in a switch, and a control circuit board 30 is disposed in the switch, that is, the carrier circuit board 11 is used as a transfer board.

The carrier circuit board 11 is disposed on the control circuit board 30, and the carrier circuit board 11 is electrically connected to the control circuit board 30, so that the control circuit board 30 is electrically connected to the electrical chip 14. The optical-electrical conversion module 12 is connected to an optical interface 211 on a panel 21 through an internal optical fiber 40, each optical interface 211 is connected to one corresponding optical-electrical conversion module 12, and the optical interface 211 is connected to an external optical fiber, so that the external optical fiber is connected to the optical-electrical conversion module 12, and the external optical fiber is connected to the electrical chip 14, to implement signal transmission between the external optical fiber and the communication device 100.

Specifically, an optical signal on the external optical fiber is transmitted to the optical-electrical conversion module 12 through the optical interface 211 and the internal optical fiber 40, the optical signal is converted into an electrical signal by the optical-electrical conversion module 12, and the output electrical signal is transmitted to the electrical chip 14 through the first conductive via 113 and the package circuit board 13, so that the signal is transmitted from the external optical fiber to the communication device 100. On the contrary, an electrical signal of the electrical chip 14 may be transmitted to the optical-electrical conversion module 12 through the package circuit board 13 and the first conductive via 113 in sequence, and converted into an optical signal by the optical-electrical conversion module 12 for output, and the optical signal is transmitted to the external optical fiber through the internal optical fiber 40 and the optical interface 211, so that the signal is transmitted from the communication device 100 to the external optical fiber.

The communication device 100 may further include a support member 50. The support member 50 may be located between the control circuit board 30 and the carrier circuit board 11. The support member 50 may be a conductive mechanical part. The control circuit board 30 may be electrically connected to the carrier circuit board 11 through the support member 50.

For example, the support member 50 may be a metal support mechanical part, or the support member 50 may be a board-to-board connector (Board to Board, which is briefly referred to as a B2B connector). Alternatively, the support member 50 may be another mechanical part that can implement an electrical connection between the carrier circuit board 11 and the control circuit board 30.

Alternatively, the support member 50 may be an insulating member disposed between the control circuit board 30 and the carrier circuit board 11, and only provides rigid support. The communication device 100 may further include a cable, and the carrier circuit board 11 may be electrically connected to the control circuit board 30 through the cable.

It should be noted that the carrier circuit board 11 is electrically connected to the control circuit board 30, so that the control circuit board 30 is connected to the electrical chip 14. The connection link is used to transmit a low-speed signal, for example, a control signal or a power supply signal, and a connection manner is relatively simple.

FIG. 11 is an assembly diagram of a co-package structure and a control circuit board according to an embodiment of this application.

As shown in FIG. 11, a vertical projection of the optical-electrical conversion module 12 onto the carrier circuit board 11 (that is, the optical-electrical conversion module 12 is projected onto the carrier circuit board 11 along a direction perpendicular to the carrier circuit board 11) is a first projection, and a vertical projection of the package circuit board 13 onto the carrier circuit board 11 (that is, the package circuit board 13 is projected onto the carrier circuit board 11 along a direction perpendicular to the carrier circuit board 11) is a second projection. The first projection and the second projection may at least partially overlap. To be specific, spaces on the carrier circuit board 11 occupied by the optical-electrical conversion module 12 and the package circuit board 13 at least partially coincide. In this way, the spaces on the carrier circuit board 11 occupied by the optical-electrical conversion module 12 and the package circuit board 13 can be reduced, which helps reduce a size of the carrier circuit board 11, and helps reduce processing difficulty and processing costs of the carrier circuit board 11.

In addition, making at least a part of the first projection overlap the second projection helps shorten a distance between the optical-electrical conversion module 12 and the package circuit board 13, and helps shorten a path of a high-speed connection link between the optical-electrical conversion module 12 and the package circuit board 13, so that the optical-electrical conversion module 12 and the package circuit board 13 can be electrically connected through the first conductive via 113.

Still refer to FIG. 11. A first pin 131 may be disposed on a surface that is of the package circuit board 13 and that faces the carrier circuit board 11, and a second pin 121 may be disposed on a surface that is of the optical-electrical conversion module 12 and that faces the carrier circuit board 11, to implement an electrical connection between the package circuit board 13 and the optical-electrical conversion module 12. The first pin 131 and the second pin 121 may be located at two ends of the first conductive via 113 respectively, and the first pin 131 and the second pin 121 may be in electrical contact and connection with the two ends of the first conductive via 113 respectively, so that the optical-electrical conversion module 12 and the package circuit board 13 can be electrically connected through the first conductive via 113.

Specifically, there may be a plurality of first pins 131 and a plurality of second pins 121, a quantity of second pins 121 may correspond to a quantity of first pins 131, and there may also be a plurality of first conductive vias 113 on the carrier circuit board 11.

It should be noted that a fifth pin 141 may be disposed on a surface that is of the electrical chip 14 and that faces the package circuit board 13, an inter-board trace 132 is disposed on the package circuit board 13, and the fifth pin 141 may be electrically connected to the first pin 131 through the inter-board trace 132, so that the electrical chip 14 is electrically connected to the package circuit board 13, and the electrical chip 14 is further electrically connected to the optical-electrical conversion module 12.

In a possible implementation, as shown in FIG. 11, the first pin 131 and the second pin 121 may be disposed at corresponding positions. In other words, a vertical projection of the first pin 131 onto the carrier circuit board 11 may coincide with a vertical projection of the second pin 121 onto the carrier circuit board 11, that is, the first pin 131 and the second pin 121 are disposed in mirror symmetry with the carrier circuit board 11 as a symmetry line.

Two ends of the first conductive via 113 are electrically connected to the first pin 131 and the second pin 121 respectively. In this way, an extension direction of the first conductive via 113 may be kept perpendicular to the carrier circuit board 11. To be specific, the extension direction of the first conductive via 113 is a direction that passes through the first pin 131 and the second pin 121 and that is perpendicular to the carrier circuit board 11, and the first conductive via 113 is a vertical via connecting the first pin 131 and the second pin 121. In this way, it is ensured that the optical-electrical conversion module 12 and the package circuit board 13 are connected directly through the first conductive via 113, and an extension length of the first conductive via 113 can be reduced. This helps further shorten a path of a connection link between the optical-electrical conversion module 12 and the electrical chip 14, and reduce a high-speed link loss.

FIG. 12 is a diagram of another optical-electrical co-package structure according to an embodiment of this application.

Alternatively, in another possible implementation, the first pin 131 and the second pin 121 may be staggered. Specifically, as shown in FIG. 12, a vertical projection of the first pin 131 onto the carrier circuit board 11 may be staggered with a vertical projection of the second pin 121 onto the carrier circuit board 11. To be specific, the vertical projection of the first pin 131 onto the carrier circuit board 11 does not coincide with the vertical projection of the second pin 121 onto the carrier circuit board 11, and the first pin 131 and the vertical projection of the second pin 121 onto the carrier circuit board 11 may be staggered in positions. This reduces constraints on an arrangement and a disposition of the first pin 131 and the second pin 121, increases flexibility of disposing the first pin 131 and the second pin 121, and enriches application scenarios of the optical-electrical co-package structure 10.

To implement an electrical connection between the first pin 131 and the second pin 121, an extension direction of the first conductive via 113 may be inclined to the carrier circuit board 11. To be specific, the extension direction of the first conductive via 113 is a direction that passes through the first pin 131 and the second pin 121 and that is inclined to the carrier circuit board 11. Alternatively, an extension direction of a part of first conductive vias 113 may be perpendicular to the carrier circuit board 11, and an extension direction of a part of the first conductive vias 113 may be inclined to the carrier circuit board 11. A specific shape and extension direction of the first conductive via 113 may be set according to a requirement, provided that the first pin 131 and the second pin 121 can be conducted through the first conductive via 113.

Still refer to FIG. 12. For example, the carrier circuit board 11 may include at least two layers of substrates 114 disposed in a stacked manner. For example, the carrier circuit board 11 includes a plurality of layers of substrates 114, one layer of the substrates faces the package circuit board 13, and another layer of the substrates faces the optical-electrical conversion module 12. Each layer of the substrates 114 may be provided with a connecting via 115. The connecting via 115 may be a metallized via that can implement electrical conduction.

Connecting vias 115 on at least two of the plurality of layers of substrates 114 are staggered. That two connecting vias 115 are staggered means that center lines of the two connecting vias 115 do not coincide and are staggered. Connecting vias 115 on two adj acent layers of the substrates are electrically connected. In this way, connecting vias 115 on the plurality of layers of substrates 114 are connected in sequence to form the first conductive via 113. A connecting via 115 located on the substrate 114 facing the package circuit board 13 may be in electrical contact and connection with the first pin 131, and a connecting via 115 located on the substrate 114 facing the optical-electrical conversion module 12 may be in electrical contact and connection with the second pin 121, so that the first pin 131 and the second pin 121 whose projections onto the carrier circuit board 11 are staggered can be conducted through the first conductive via 113.

For example, as shown in FIG. 12, the carrier circuit board 11 may include five layers of substrates 114 disposed in a stacked manner, each layer of the substrates 114 is provided with a connecting via 115, an extension direction of the connecting via 115 may be perpendicular to the substrate 114, two connecting vias 115 on two adjacent layers of the substrates 114 are staggered, and connecting vias 115 on two adjacent layers of the substrates 114 are electrically connected to form the first conductive via 113. A connecting via on a substrate adjacent to the package circuit board 13 is in electrical contact and connection with the first pin 131, and a connecting via on a substrate adjacent to the optical-electrical conversion module 12 is in electrical contact and connection with the second pin 121, so that the package circuit board 13 and the optical-electrical conversion module 12 are electrically connected through the first conductive via 113.

A cross-sectional shape of the connecting via 115 may be a regular or irregular shape, for example, a trapezoid, a quadrilateral, or a triangle, and a specific shape may be set according to an actual requirement.

Still refer to FIG. 12. A metal layer 116 may be disposed between two connecting vias 115 on two adjacent layers of the substrates 114, and the connecting vias 115 on the two adjacent layers of the substrates 114 may be electrically connected through the metal layer 116, to form the first conductive via 113. Because the connecting vias on the two adjacent layers of the substrates are staggered, instability of an electrical connection between the two connecting vias is likely to occur due to the stagger. The connecting vias on the two adjacent layers of the substrates are electrically connected through the metal layer 116, and the metal layer can effectively increase an electrical contact area between the two connecting vias, so that stability of a connection between the connecting vias 115 is improved.

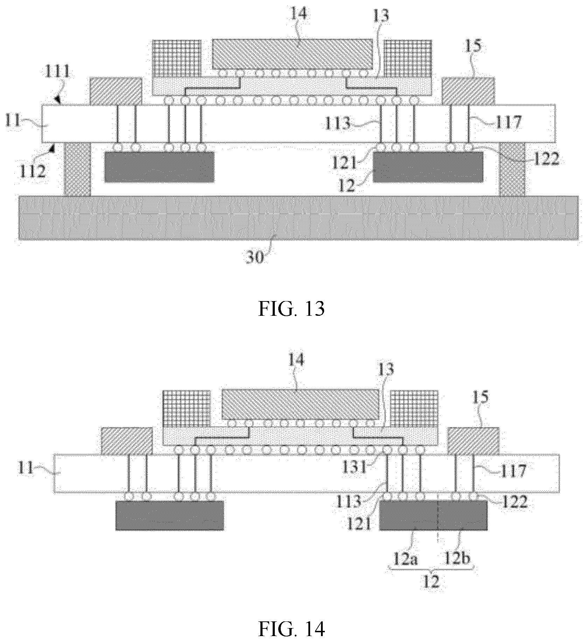

FIG. 13 is another assembly diagram of an optical-electrical co-package structure and a control circuit board according to an embodiment of this application.

As shown in FIG. 13, the optical-electrical co-package structure 10 may further include a power supply module 15. The power supply module 15 is electrically connected to the optical-electrical conversion module 12, and the power supply module 15 is configured to supply power to the optical-electrical conversion module 12, to help ensure stability and flexibility of supplying power to the optical-electrical conversion module 12.

The power supply module 15 may be disposed on the carrier circuit board 11, to improve integration of the entire optical-electrical co-package structure 10. Alternatively, the power supply module 15 may be disposed on the control circuit board 30 of the communication device 100.

When the power supply module 15 is disposed on the carrier circuit board 11, the power supply module 15 may be specifically disposed on the first side surface 111 of the carrier circuit board 11, that is, the power supply module 15 and the package circuit board 13 are located on a same surface of the carrier circuit board 11. Alternatively, the power supply module 15 may be disposed on the second side surface 112 of the carrier circuit board 11, that is, the power supply module 15 and the optical-electrical conversion module 12 are located on a same surface of the carrier circuit board 11.

As shown in FIG. 13, the power supply module 15 is disposed on the first side surface 111 of the carrier circuit board 11, and the optical-electrical conversion module 12 is disposed on the second side surface 112 of the carrier circuit board 11, that is, the power supply module 15 and the optical-electrical conversion module 12 are located on two opposite side surfaces of the carrier circuit board 11.

The carrier circuit board 11 may be further provided with a second conductive via 117, so that the power supply module 15 and the optical-electrical conversion module 12 can be electrically connected directly through the second conductive via 117, without using an inter-board trace (for example, a trace of the carrier circuit board 11) to connect the power supply module 15 to the optical-electrical conversion module 12. This helps shorten a path of a connection link and further reduce a link loss.

In addition, this helps reduce active layers on the carrier circuit board 11, to reduce a layer quantity of the carrier circuit board 11, and reduce processing costs and processing difficulty of the carrier circuit board 11.

The second conductive via 117 is also a metallized via, and may be a through hole, a blind hole, a buried hole, or the like that is provided on the carrier circuit board 11. A metallization manner may also be electroplating and filling, hole plugging, or the like.

A third pin 122 may be further disposed on the surface that is of the optical-electrical conversion module 12 and that faces the carrier circuit board 11, a fourth pin (not shown in the figure) may be disposed on the power supply module 15, and two ends of the second conductive via 117 may be in electrical contact and connection with the third pin 122 and the fourth pin respectively, so that the power supply module 15 and the optical-electrical conversion module 12 are electrically connected through the second conductive via 117.

In other words, the second pin 121 of the optical-electrical conversion module 12 is configured to transmit a high-speed signal, to implement a high-speed connection between the optical-electrical conversion module 12 and the electrical chip 14. The third pin 122 of the optical-electrical conversion module 12 may be configured to transmit a low-speed signal, for example, a control signal or a power supply signal, and a connection is relatively simple.

FIG. 14 is a diagram of still another optical-electrical co-package structure according to an embodiment of this application.

As shown in FIG. 14, the optical-electrical conversion module 12 may be divided into a first part 12a and a second part 12b. A vertical projection of the first part 12a onto the carrier circuit board 11 is located inside the second projection (that is, the projection of the package circuit board 13 onto the carrier circuit board 11). In other words, the vertical projection of the first part 12a onto the carrier circuit board 11 overlaps the second projection. A vertical projection of the second part 12b onto the carrier circuit board 11 is located outside the second projection. In other words, the vertical projection of the second part 12b onto the carrier circuit board 11 does not overlap the second projection.

The first pin 131 is located on the first part 12a. In other words, a projection of the first pin 131 onto the carrier circuit board 11 is located inside the second projection, so that projections of the first pin 131 and the second pin 121 onto the carrier circuit board 11 coincide, and the first pin 131 is electrically connected to the second pin 121 through a vertical first conductive via 113.

The third pin 122 is located on the second part 12b. In other words, a projection of the third pin 122 onto the carrier circuit board 11 is located outside the second projection. A position of the third pin 122 may correspond to a position of the fourth pin. In other words, the projection of the third pin 122 onto the carrier circuit board 11 may coincide with a projection of the fourth pin onto the carrier circuit board 11, and the third pin 122 and the fourth pin are disposed in mirror symmetry with the carrier circuit board 11 as a symmetry line.

In this way, an extension direction of the second conductive via 117 may be kept perpendicular to the carrier circuit board 11. To be specific, the extension direction of the second conductive via 117 is a direction that passes through the third pin 122 and the fourth pin and that is perpendicular to the carrier circuit board 11. In this way, it is ensured that the optical-electrical conversion module 12 and the power supply module 15 are connected directly through the second conductive via 117, and an extension length of the second conductive via 117 can be reduced. This helps further shorten a path of a connection link between the power supply module 15 and the optical-electrical conversion module 12, reduce a link loss, and improve power supply efficiency of a power module.

Finally, it should be noted that the foregoing embodiments are merely intended to describe the technical solutions of embodiments of this application, and are not intended to limit embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. An optical-electrical co-package structure, comprising a carrier circuit board, an optical-electrical conversion module, a package circuit board, and an electrical chip, wherein
the carrier circuit board comprises a first side surface and a second side surface opposite to the first side surface, the package circuit board is located on the first side surface, the electrical chip is disposed on the package circuit board, the electrical chip is electrically connected to the package circuit board, and the optical-electrical conversion module is disposed on the second side surface; and
the carrier circuit board is provided with a first conductive via, and the optical-electrical conversion module is electrically connected to the package circuit board through the first conductive via.

2. The optical-electrical co-package structure according to claim 1, wherein a vertical projection of the optical-electrical conversion module onto the carrier circuit board is a first projection, a vertical projection of the package circuit board onto the carrier circuit board is a second projection, and at least a part of the first projection overlaps the second projection.

3. The optical-electrical co-package structure according to claim 1 or 2, wherein a first pin is disposed on a surface that is of the package circuit board and that faces the carrier circuit board, a second pin is disposed on a surface that is of the optical-electrical conversion module and that faces the carrier circuit board, and two ends of the first conductive via are electrically connected to the first pin and the second pin respectively.

4. The optical-electrical co-package structure according to claim 3, wherein a vertical projection of the first pin onto the carrier circuit board coincides with a vertical projection of the second pin onto the carrier circuit board, and an extension direction of the first conductive via is perpendicular to the carrier circuit board.

5. The optical-electrical co-package structure according to claim 3, wherein a vertical projection of the first pin onto the carrier circuit board is staggered with a vertical projection of the second pin onto the carrier circuit board.

6. The optical-electrical co-package structure according to claim 5, wherein the carrier circuit board comprises at least two layers of substrates disposed in a stacked manner; and
each layer of the substrates is provided with a connecting via, the connecting vias on at least two layers of the substrates are staggered, and the connecting vias on two adjacent layers of the substrates are electrically connected to form the first conductive via.

7. The optical-electrical co-package structure according to claim 6, wherein the carrier circuit board further comprises a metal layer, the metal layer is disposed between the connecting vias on two adjacent layers of the substrates, and the connecting vias are connected through the metal layer.

8. The optical-electrical co-package structure according to any one of claims 1 to 7, wherein the first conductive via comprises a through hole, a blind hole, or a buried hole.

9. The optical-electrical co-package structure according to any one of claims 2 to 8, further comprising a power supply module, wherein the power supply module is electrically connected to the optical-electrical conversion module, and the power supply module is disposed on the carrier circuit board.

10. The optical-electrical co-package structure according to claim 9, wherein the carrier circuit board is further provided with a second conductive via, the power supply module is disposed on the first side surface, and the power supply module is electrically connected to the optical-electrical conversion module through the second conductive via.

11. The optical-electrical co-package structure according to claim 10, wherein a third pin is disposed on the surface that is of the optical-electrical conversion module and that faces the carrier circuit board, a fourth pin is disposed on the power supply module, and two ends of the second conductive via are connected to the third pin and the fourth pin respectively.

12. The optical-electrical co-package structure according to claim 11, wherein the optical-electrical conversion module comprises a first part and a second part, a vertical projection of the first part onto the carrier circuit board overlaps the second projection, a vertical projection of the second part onto the carrier circuit board is located outside the second projection, the first pin is located on the first part, and the third pin is located on the second part; and
a vertical projection of the third pin onto the carrier circuit board coincides with a vertical projection of the fourth pin onto the carrier circuit board, and an extension direction of the second conductive via is perpendicular to the carrier circuit board.

13. A communication device, comprising at least a housing and the optical-electrical co-package structure according to any one of claims 1 to 12, wherein the optical-electrical co-package structure is disposed in the housing; and
the housing is provided with an optical interface configured to connect to an external optical fiber, and the optical interface is connected to the optical-electrical conversion module.

14. The communication device according to claim 13, further comprising a control circuit board, wherein the carrier circuit board is disposed on the control circuit board, and the carrier circuit board is electrically connected to the control circuit board.

15. The communication device according to claim 14, further comprising an internal optical fiber located in the housing, wherein the optical interface is connected to the optical-electrical conversion module through the internal optical fiber.
